# EUROPEAN PATENT APPLICATION

(11) **EP 2 290 704 A1**
(43) Date of publication of application: **02.03.2011**
(21) Application number: 09168864.8
(22) Date of filing: 27.08.2009
(51) Int. Cl.: H01L 31/18, H01L 31/068

(54) **Passivation layer for wafer based solar cells and method of manufacturing thereof**

(71) Applicant: Applied Materials, Inc., Santa Clara, CA 95054 (US)
(72) Inventor: Englert, Manfred, 63526, Erlensee (DE); Schramm, Sven, 63796, Kahl am Main (DE); Trassl, Roland, 35392, Giessen (DE)
(74) Representative: Zimmermann & Partner

(57) **Abstract**

A solar cell module layer stack is described. The layer stack includes a doped silicon wafer substrate 101, a back contact layer 104 for the solar cell module, and a first sputtered and annealed passivation layer 112 between the wafer substrate and the back contact layer, wherein the passivation layer is selected from the group consisting of: an aluminum containing oxide layer, an aluminum containing nitride layer, an aluminum containing oxynitride layer, and mixtures thereof.

## Description

### TECHNICAL FIELD OF THE INVENTION

Embodiments of the present invention relate to passivation of wafer based solar cells. Particularly, they relate to reactively-sputtered, aluminum-containing passivation layers and methods of depositing same. Specifically, they relate to a solar cell layer stack and a method of manufacturing a solar cell layer stack.

### BACKGROUND OF THE INVENTION

Photovoltaic (PV) cells or solar cells are material junction devices which convert sunlight into direct current (DC) electrical power. When exposed to sunlight, i.e. photons, the electric field of solar cell p-n junctions separates pairs of electrons and holes, thus generating a photo-voltage. A circuit from n-side to p-side allows the flow of electrons when the solar cell is connected to an electrical load, while the area and other parameters of the PV cell junction device determine the available current.

Solar cells have evolved significantly over the past two decades, with experimental efficiencies increasing from less than about 5% in 1980 to almost 40% in 2008. The most common solar cell material is silicon, which is used, for example, in the form of single or polycrystalline wafers. Because the amortized cost of forming silicon-based solar cells to generate electricity is higher than the cost of generating electricity using traditional methods, there has been an effort to reduce the cost of manufacturing solar cells. Thereby, high light conversion efficiencies have to be provided at reduced costs.

Further, the existing efficiency of a PV module has to be stable over the lifetime of the module in order to allow for high acceptance of the modules by the consumer. In order to achieve high efficiencies, low manufacturing costs and long time stability of the final PV module, covering layers and intermediate layers for passivation, high efficiencies, i.e. desired optical properties, and desired properties for the manufacturing process are used.

Besides improvements in the area of the p-n junction, improvements of the covering and intermediate layers are also desired to achieve the desired costs per watt with desired long term stability.

### SUMMARY OF THE INVENTION

In light of the above, a solar cell layer stack according to independent claim 1 and a method of manufacturing a solar cell layer stack according to independent claim 11 are provided.

According to one embodiment, a solar cell layer stack is provided. The solar cell layer stack includes a doped silicon wafer substrate; a further layer deposited on the substrate, wherein the further layer is doped for generation of a p-n-junction with the doped silicon wafer substrate; and a first sputtered and annealed passivation layer deposited on the doped silicon wafer substrate or the further layer, wherein the passivation layer is selected from the group consisting of: an aluminum containing oxide layer, an aluminum containing oxynitride layer, and mixtures thereof.

According to a further embodiment, a method of manufacturing a solar cell layer stack is provided. The method includes providing a doped silicon wafer substrate, depositing a further layer on the substrate, wherein the further layer is doped for generation of a p-n-junction with the doped silicon wafer substrate, and reactive sputtering a passivation layer on the doped silicon wafer substrate or on the further layer . The reactive sputtering includes flowing an unreactive gas and an oxygen containing gas, or an unreactive gas and an oxygen containing gas and a nitrogen containing gas in the processing region for depositing the passivation layer. The method of manufacturing further includes annealing the passivation layer.

### BRIEF DESCRIPTION OF THE DRAWINGS

So that the manner in which the above recited features of the present invention can be understood in detail, a more particular description of the invention, briefly summarized above, may be had by reference to the embodiments. The accompanying drawings relate to embodiments of the invention and are described in the following:

Figure 1 shows a schematic view of a layer stack for a solar cell or solar cell module, respectively, according to embodiments described herein;

Figure 2 shows a schematic view of a further layer stack for a solar cell or a solar cell module, respectively according to further embodiments described herein;

Figure 3 shows a system for depositing a layer stack according to embodiments described herein; and

Figure 4 shows a flow chart illustrating a method of manufacturing a layer stack according to embodiments described herein.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer to layer stacks for solar cells or solar modules which are based on silicon wafers. Thereby, a passivation layer is sputtered. According to typical embodiments described herein, a reactive sputtering process is used for sputtering the solar cell or the corresponding layer stack. According to yet further embodiments, which can be combined with other embodiments described herein, the middle frequency sputtering having frequencies in the range of 5 kHz to 100 kHz, for example, 30 kHz to 50 kHz, can be provided for manufacturing the solar cell layer stack. According to yet even further embodiments, typically n-doped or p-doped wafers can be used. However, especially for high efficiency solar cell modules, n-doped wafers can be used for embodiments described herein.

The sputtering, for example the reactive sputtering, described for embodiments of passivation layers generally refers to sputtering of aluminum oxide, aluminum nitride, or aluminum oxynitride (AlO_{X}N_{Y}.) Such layers have been found to be especially useful for passivation of crystalline solar cells. Thereby, for example, the middle frequency process in the frequency range described above can be used to deposit a dielectric layer that contains aluminum.

Typically, according to some embodiments, which can be combined with other embodiments described herein, the use of n-type silicon wafers results in a long term stability of the cell efficiency of a solar cell. However, the use of silicon oxide for passivation of, for example n-type silicon wafers, has not shown the desired properties.

Accordingly, an alternative passivation layer for wafer-based solar cells is desired. The inventors of the present invention found that reactively sputtered aluminum containing oxide layers, or reactively sputtered aluminum containing oxynitride layers according to embodiments described herein and/or manufactured according to embodiments described herein can improve the passivation of the doped wafer substrate and, thereby, the solar cell efficiency and the long-term stability of the solar cell efficiency.

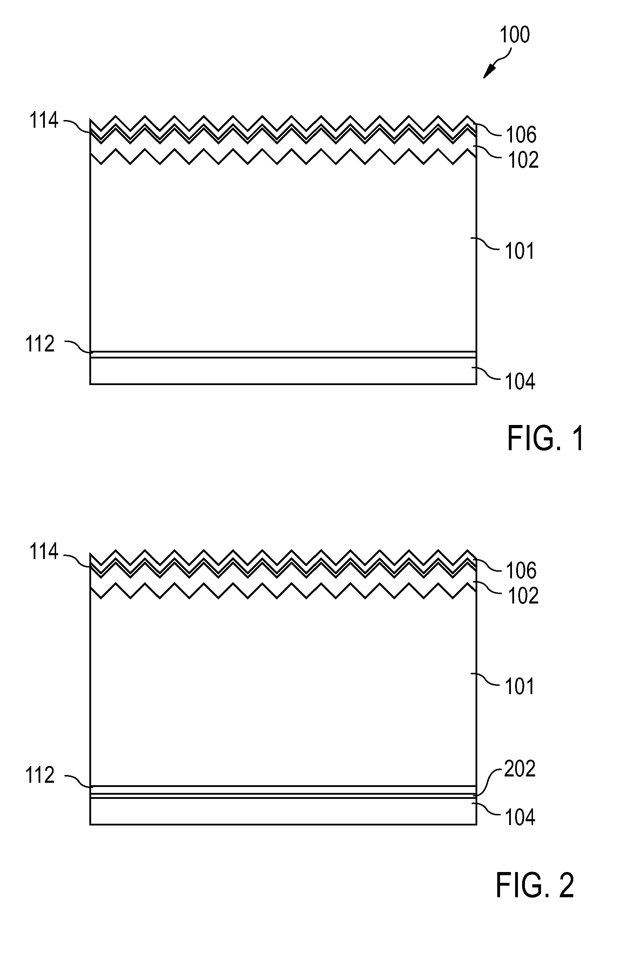

As shown in figure 1, a doped silicon wafer substrate 101 can be used for depositing the individual layers on the substrate for forming the layer stack of a solar cell. Thereby, a p-type wafer or an n-type wafer can be used. However, typically an n-type silicon wafer might be used for long term stability of high cell efficiencies.

In Fig. 1, on the one hand, a further doped silicon layer 102 is shown to be deposited on the substrate 101. Thereby, the doped silicon layer has a doping to generate at p-n-junction for generation of the solar cell. Accordingly, if an n-type wafer 101 is used, a p-type layer 102 is deposited. If a p-type wafer 101 is used, an n-type layer 102 is deposited to form the p-n-junction.

As shown in figure 1, the layers stack 100 further includes a passivation layer 114 deposited on the doped silicon layer 102 and an anti-reflection coating 106.

In Fig. 1, on the other hand, on the backside of the substrate 101, a back contact 104, which is typically made of aluminum, is provided. Between the wafer 101 and the back contact 104, a passivation layer 112 is deposited. As will be understood by a person skilled in the art, the passivation layer 112 is typically deposited on the doped silicon wafer substrate 101 before the back contact 104 is provided.

As described above, figure 1 shows a layer stack having at least the first passivation layer on the back side of the layer stack. For easier understanding, through-contacts from the back contact 104 to the substrate 101 and contacts on the front surface of the layers stack are omitted. Generally, in the illustration shown in figure 1, the top side of the layer stack 100 will be referred to as the front surface of the layer stack, i.e. the surface through which photons enter the solar cell, and the bottom portion of the layers in Fig. 1 will be referred to as the back surface of the solar cell.

According to embodiments described herein, one or both of the passivation layers 112 and 114, typically at least the passivation layer 112 at the backside of the layers stack 100, is a sputtered aluminum oxide layer, a sputtered aluminum nitrite layer, or a sputtered aluminum oxynitride layer. The sputtering can be conducted as a reactive sputtering, wherein argon as an un-reactive gas and oxygen and/or nitrogen are used as reactive gases. According to some embodiments, which can be combined with other embodiments described herein, hydrogen is not used as a process gas for reactive sputtering of the Al₂O₃ layer. According to some embodiments, the aluminum containing passivation layer according to embodiments described herein, can at least be provided on the p-doped side of the two layers 101 and 102, that is the doped substrate (101) and the further doped layer (102). The layer 102 can also be referred to as the emitter.

Thereby, it should be noted that a sputtered Al₂O₃ layer is different from Al₂O₃ layers deposited by other deposition methods such as ALD, SACVD, CVD, or PECVD. Whether or not an Al₂O₃ layer is sputtered can be determined by the plurality of evaluation methods such as SEM, TEM or the like. Providing the desired layer properties for the aluminum containing dielectric passivation layers described herein is not derivable or obvious over corresponding layers provided by a different deposition method. Further, the desire to reduce the costs per watt for solar cell modules requires a deposition rate of, for example, 5 nm/min to 50 nm/min. Accordingly, for embodiments of manufacturing a layer stack for a solar cell as described herein, a deposition rate of at least 5 nm/min, typically of 5 nm/min to 40 or even 50 nm/min, is provided.

According to different embodiments, which can be combined with other embodiments described herein, the Al₂O₃ layer can be an aluminum oxide (Al₂O₃) layer, Al2O_{X} (x being in the range of e.g. 2.5 to 3), such as an Al₂O_{2.9} layer, or an aluminum oxide layer with at least 40 atomic % of oxygen. In the event the layer is not an Al₂O₃ yer, i.e. the deposited aluminum layer is not fully oxidized, the remaining material occurs, for example, as aluminum or another appropriate material. According to yet further embodiments, the passivation layer can be an Al₂O_{X} layer wherein X is from about 2.5 to 3 or the passivation layer can be an AlO_{X}N_{Y} layer wherein X is from about 2.5 or to 2.9.

According to yet further embodiments, also the optical properties such as the refractive index of the passivation layer needs to be considered for providing a high efficiency solar cell, as the solar cell is also an optical device. Typically, the Al₂O₃ layer can have a refractive index of 1.5 to 2.1 such as, for example, 1.6, 1.65 or 1.9. Thereby if X is reduced in Al₂O_{X}, the refraction index is increased. Generally, if reference is made to values of a refractive index herein, the values are measured according to typical experimental setups, e.g., at a wavelength of 589 nm and under one of the accepted standard conditions for temperature and pressure.

Accordingly, the sputtering of the passivation layer can be used to adjust the refractive index of the layer by adding materials like nitrogen or by not fully oxidizing the layer.

According to some embodiments of manufacturing a solar stack, argon, oxygen and nitrogen are introduced in the processing region of the sputtering process. Thereby, variation of those gases influences the composition of the passivation layer. The gases also influence the deposition rate of the Al₂O₃ layer during the process. For example, nitrogen can be provided at a flow rate of 0.5 to 1.1 times the flow rate of oxygen, wherein none or only a minority of the nitrogen is incorporated in the layer but serves for process improvements such as process stability, deposition rate, or the like. According to yet further embodiments, which can be combined with other embodiments described herein, the deposition of the passivation layer can be conducted at low powers and/or low pressures. Typically, the power density can be in the range of 1 W/cm² to 10 W/cm² and/or the pressure can be in the range of 1*10⁻³ mbar to 9*10⁻³ mbar, for example 1.5*10⁻³ mbar to 8*10⁻³ mbar. Thereby, also the power and the pressure can be used to influence the deposition rate and the refraction index of the deposited aluminum oxynitride layer.

According to the embodiments described herein, after the deposition step, an annealing step of the passivation layer is conducted. Thereby, for example, air or nitrogen might be used to generate the environment during an annealing and temperatures ranging from 300°C to 1200°C can be used. According to typical embodiments, which can be combined with other embodiments described herein, the temperature influences the process time. Both temperature and time may depend on the thickness of the Al2O3 layer. According to typical embodiments, annealing can take place from about 30 sec to about 30 min, typically from 2 min to 15 min or typically from 3 min to 8 min.

As shown in figure 1, the front surface of the wafer substrate 101 has a structured or textured surface. This allows for better light conversion efficiency because more photons enter the active area of the solar cell layer stack. According to some embodiments, which can be combined with other embodiments described herein, the thicknesses of the passivation layer 112 and/or 114, respectively, can be in a range of 10 nm to 100 nm, typically in a range of 20 nm to 80 nm.

As described above, typically the passivation layer on the back side of the solar cell layer stack, i.e. the passivation layer 112, which is an AlO_{X}N_{Y} layers according to embodiments described herein, is provided for improvement of the cell efficiency and, particularly, the long-term cell efficiency of a solar cell module. According to yet further embodiments, which can be combined with other embodiments described herein, the passivation layer 114, the passivation layer 112 or both passivation layers 112 and 114 can be provided as a AlO_{X}N_{Y} layer as described herein. Thereby, the aluminum containing dielectric passivation layers can be particularly desirable for high-quality wafer-based solar cells. Solar cells, which are based on lower quality silicon wafers, might benefit from hydrogen that can diffuse through passivation layers, particularly from the anti-reflection coating 106. Particularly if high quality doped silicon wafer substrates are used, this diffusion of hydrogen might not be required or can even be disadvantageous. Accordingly, the AlO_{X}N_{Y} passivation layers according to embodiments described herein can be optimized with respect to other parameters such as long-term stability and optical behavior, because diffusion aspects do not need to be taken into account. A further advantage of the AlO_{X}N_{Y} passivation layers can be the high temperature stability and its inertness with respect to aluminum allowing a high deposition rate aluminum evaporation in a subsequent layer, e.g. a back contact layer 104 shown on Figs 1 and 2. A yet further advantage of AlO_{X}N_{Y} passivation layers due to the high thermal stability can be that the AlO_{X}N_{Y} passivation layers can serve as a mask for selective front-side texturing.

According to some embodiments of manufacturing a solar cell layer stack, the reactive sputtering can be conducted while the substrate is at substantially room temperature, i.e. the substrate is not additionally heated by heating sources but merely increases its temperature by the energy provided due to the deposition process. For example, the substrate might have a temperature of 50°C or below. Thereby, according to specific implementations, which can be combined with other embodiments described herein, hydrogen is not used as a processing gas for the reactive sputtering of the AlO_{X}N_{Y} layer. Even though on first sight hydrogen might be considered as providing an improvement to the properties of the passivation layer, such an improvement might show the reverse effect, i.e. a lower quality with respect to the desired characteristics, after annealing of the passivation layer. According to yet further embodiments, which can be combined with other embodiments described herein, the aluminum containing oxide layer may also be sputtered at high temperatures such as substrate temperatures of 400 °C or less.

Further embodiments of layer stacks for solar cells or solar cell modules, respectively, will now be described with respect to figure 2. Thereby, in addition to the above described embodiments, the passivation properties can be further improved by depositing another dielectric layer, for example silicon nitrite, on the AlO_{X}N_{Y} layer. As shown in figure 2, the further dielectric layer 202, such as silicon nitride layer, is provided between the doped silicon wafer substrate 101 and the back contact 104. Besides further improvement of the passivation, this might also yield to better optical properties. Depending on the thickness and composition of such layer, for example silicon nitride can be used as the reflective layer such that photons entering the layer stack from the front surface and passing through the solar cell layer stack without generating an electron-hole-pair in the active region of the solar cell are reflected back into the active region. The probability of generation of an electron-hole pair is thereby increased.

According to yet further embodiments, which can be combined with other embodiments described herein, the passivation layer can have a passivation assist layer, such as for example, aluminum nitride, silicon nitride or another dielectric layer. As described below, the deposition rate of aluminum oxide might be comparably low. Thus, it might be beneficial for improvement of throughput if the aluminum containing oxide layer or the aluminum containing oxynitride layer is grown as thin as possible and is further assisted by passivation assist layer like AIN, SiN or the like. Accordingly, as one example, the layer stack shown in Fig. 2 might have a further AIN layer between the layer 112 and the layer 202.

According to yet further embodiments, the further dielectric layer on top of the other passivation layer 114 (not shown in figure 2) might also improve the passivation layer properties. Thereby, however, the optical properties need to be optimized for having photons transmitted into the solar cell layer stack and not for reflecting photons as described with respect to the back side above.

Typically, the aluminum containing oxide layer or the aluminum containing oxynitride layer can be used for passivation of e.g., the p-doped silicon wafer substrate. Thereby, a passivation of the doped layer occurs also in light of the charge of the respective layer. Even though a Al containing passivation layer 114 similar to the backside passivation layer might not bee straight forward as generally the doping of layer 102 is different from the doping of the substrate 101, there might be more complex or more sophisticated silicon layer stacks with respective doping profiles that the aluminum containing oxide layer or the aluminum containing oxynitride layer can be used at a back side and at a front side of the layer stack.

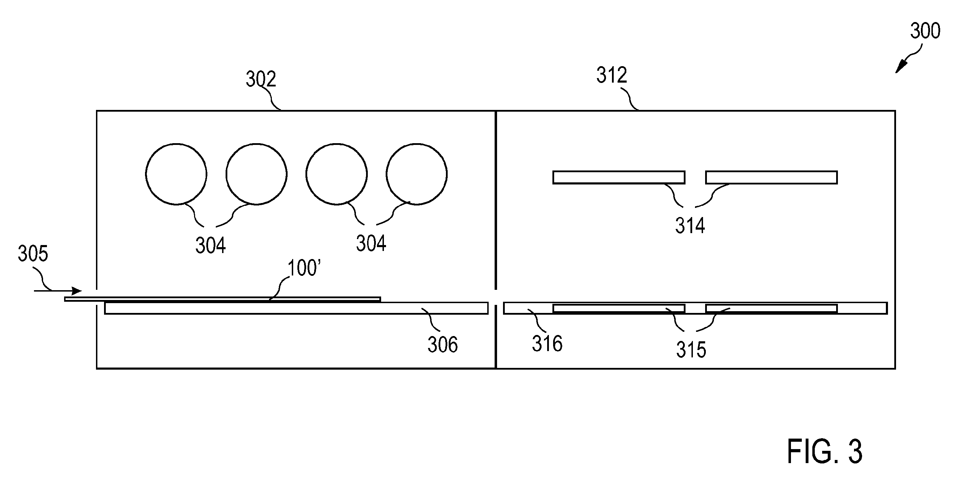

Figure 3 illustrates a system 300 that can be used for manufacturing an AlO_{X}N_{Y} passivation layer according to embodiments described herein. The system 300 includes two or more chambers. Figure 3 illustrates the first chamber 302 and a second chamber 312. The substrate 100' or a plurality of substrates, which can, for example, be provided on a carrier, enters the first chamber 302 through a slit in the chamber wall. For example, the substrate might be inserted from the preceding chamber (not shown), a load lock chamber or the like. Thereby, the arrangement of chambers allows for low-pressure process in the chamber 302. Within the chamber 302, the substrate is guided on a substrate support 306.

In the case of an in-line process the substrate moves continuously along direction 305 while deposition of the passivation layer is conducted. Alternatively, a stationary deposition process can be provided when the substrate is first moved into the chamber 302 and deposition starts after the substrate has been positioned in the deposition region.

The example shown in figure 3 includes four rotatable sputtering cathodes 304, which provide the material to be sputtered, i.e. aluminum, to the processing region. According to yet further embodiments, which can be combined with other embodiments described herein, two or more cathodes can be provided wherein those cathodes can be planar cathodes or rotatable cathodes. However, rotatable cathodes can result in reduced manufacturing costs and thus, an improved cost per watt of the solar cell. Typically, magnetron sputtering is conducted. As described above, reactive sputtering can be provided by flowing reactive gases like oxygen, oxygen containing gases, nitrogen, nitrogen containing gases, carbon containing gases and/or mixtures thereof and un-reactive gases like argon, xenon or the like (typically argon) in the processing region. Thereby, the sputtered aluminum reacts with the reactive gases and forms the desired aluminum oxide layer, aluminum nitride layer or aluminum oxynitride layer.

After the passivation layer has been deposited by a reactive sputtering process on the silicon substrate wafer or the additional silicon film (see layers 101 and 102, respectively in figures 1 and 2) the substrate is transferred to the second chamber 312. Therein, the substrate support 316 is provided. Further, heating units 314 and 315 are provided in the chamber in order to conduct the annealing process. According to different embodiments, heating units 314 opposing the deposited surface can be provided in the chamber 312. According to alternative or additional modifications thereof, heating units 315 below the silicon wafer substrate can be provided. The latter can be provided below or within the substrate support for heating the wafer from the side opposing the deposited layer.

Examples of a heating units and substrate supports are described in a co-pending application filed by the applicant and entitled "SUBSTRATE TRANSPORT SYSTEM AND METHOD", which is incorporated herein by reference to the extent that the applications are not inconsistent with this disclosure.

As shown in Fig. 3, a system includes at least a deposition chamber for a AlO_{X}N_{Y} passivation layer and an annealing chamber for the deposited passivation layer. However, according to yet further embodiments, further chambers can be provided in the system to deposit two or more of the layers in the layer stacks according to embodiments described herein, and as exemplarily shown in Figs. 1 and 2. Thereby, according to some embodiments, which can be combined with other embodiments described herein, a further chamber (not shown in Fig. 3) can be provided which is vacuum sealed communication with respect to the first chamber 302 such that a first passivation layer and a second passivation layer can be deposited without the substrate 100' leaving the vacuum. Thereby, at least on of the passivation layers is a sputtered AlO_{X}N_{Y} passivation layer and an anneal process component is provided after sputter deposition of the AlO_{X}N_{Y} passivation layer, see e.g. chamber 312 in Fig. 3. Typically, according to some embodiments, the annealing is conducted in an rapid thermal anneal chamber or the annealing can be conducted in an integrated in-situ rapid thermal anneal station post the AlO_{X}N_{Y} deposition, for example in the deposition chamber for depositing the passivation layer itself.

As described above, the system is adapted for depositing the layers of the layer stack or at least the front-side passivation layer and the back-side passivation layer of the layer stack without breaking the vacuum for the substrate. Thereby, adjacent chambers can be vacuum sealed with respect to each other, intermediate chambers for transfer of the substrate from a front-side passivation deposition chamber to a back-side passivation deposition layer can be provided, wherein the intermediate chamber are adapted for transferring the substrate under vacuum conditions, or different deposition regions for the front-side passivation layer and the back-side passivation layer can be provided within one chamber, which is adapted for low pressure operation as described above.

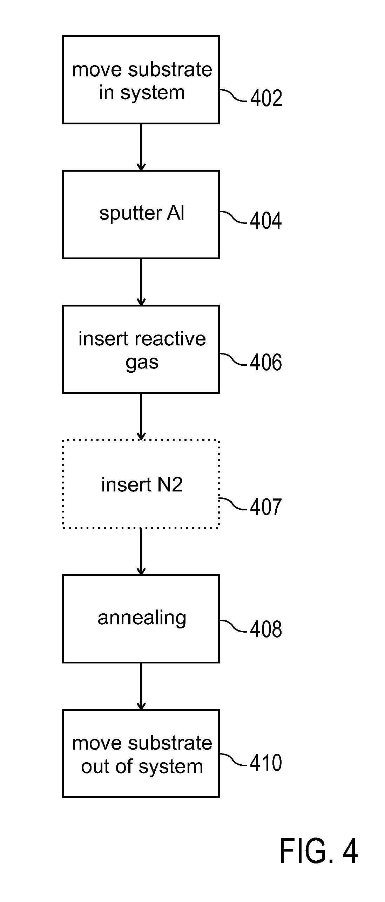

Figure 4 illustrates yet further embodiments of methods of manufacturing at solar cell layer stack. In step 402 a substrate, for example a doped wafer substrate, is inserted in a processing system for manufacturing the layer stack. In step 404, aluminum is sputtered to deposit and aluminum containing dielectric layer, wherein in step 406 a reactive gas such as oxygen and, optionally in step 407 nitrogen as a further reactive gas, is inserted in the deposition region of the sputtering system. As already described above, according to yet further embodiments, which can be combined with other embodiments described herein, also un-reactive gases like argon can be inserted in the chamber, that is the processing region for the reactive sputtering.

Embodiments of aluminum containing oxide layers or aluminum containing oxynitride layers as described herein can provide an improvement for the efficiency of the solar cell or a solar cell module respectively. Thereby, it is typically understood that an aluminum containing oxide layer or aluminum containing oxynitride layer should be an aluminum based layer. For example the aluminum content should be at least 10 atomic %, at least 20 atomic % or even at least 30%.

Examples, wherein Al2O3 is reactively sputtered show an improvement of the lifetime of electron-hole-pairs in the sample. As compared to reference samples with SiO showing a lifetime of the electron-hole-pairs of about 300 µs, the lifetime in Al2O3 after annealing was about 430 µs for a 60 nm thick Al2O3 layer and about 550 µs for a 100 nm thick Al2O3 layer. These results are examples given at a 5 min annealing at 700 °C under air atmosphere.

According to yet further examples, the lifetime of electron-hole-pairs can be increased by a factor of 4 when the oxygen content in the process is increased from about 50 % oxygen to 100 % oxygen of the mixture of oxygen and nitrogen, wherein 100 % corresponds to Al₂O₃ that is 60 atomic % oxygen in the layer. However, at the same time the deposition rate of the aluminum containing oxynitride layer is reduced also by a factor of 3 to 4 when the oxygen content is increased as above. Accordingly, the flowing of nitrogen in the processing region can improve throughput by increasing the deposition rate. It is however preferred to have a high oxygen content in the sputtered layer in order to increase the lifetime of the electron-hole-pairs and thereby the cell efficiency.

According to some embodiments, hydrogen is not flowed into the processing region during the reactive sputtering process. In step 408 the sputtered aluminum containing dielectric passivation layer is annealed in step 408 under conditions, which are for example described herein above. In step 410, the substrate is moved out of the system. As will be understood by a person skilled in the art, further deposition steps or processing steps of the layer stack for solar cell or solar cell module, respectively, can be conducted before the substrate is moved out of the processing system. According to yet further embodiments, similar steps as described with respect to step 404, 406, 407, and 408, can be provided for a second aluminum containing passivation layer such that a formula passivation layer is also provided on an opposing side of the substrate.

In light of the above a plurality of embodiments has been described. For example, a solar cell layer stack is provided, wherein the layer stack includes a doped silicon wafer substrate; a further layer deposited on the substrate, wherein the further layer is doped for generation of a p-n-junction with the doped silicon wafer substrate; and a first sputtered and annealed passivation layer deposited on the doped silicon wafer substrate or the further layer, wherein the passivation layer is selected from the group consisting of: an aluminum containing oxide layer, an aluminum containing nitride layer, an aluminum containing oxynitride layer, and mixtures thereof. For example, the aluminum content of aluminum containing layers comprising mainly an aluminum oxide or aluminum oxynitride should be at least 10 atomic %, at least 20 atomic % or even at least 30 atomic %. According to some embodiments, which can be combined with other embodiments described herein, the aluminum content can be up to 50 %. According to optional modifications thereof, the first passivation layer can be selected from the group consisting of: the first passivation layer comprises Al₂O_{X} or being an Al₂O_{X} layer wherein X is in the range of 2 to 3, the first passivation layer having an average oxygen content of 40% atomic oxygen or more in the form of aluminum oxide, and the first passivation layer comprises AlO_{X}N_{Y} or being an AlO_{X}N_{Y} layer and wherein X is in the range of 2 to 2.9. As yet further optional or alternative modifications, the first passivation layer can have a refractive index of 1.55 to 2.1. According to yet further embodiments, which can be combine with other embodiments described herein, a further sputtered and annealed passivation layer on the side of the wafer substrate opposing the first sputtered and annealed passivation layer can be provided, wherein the further passivation layer is selected from the group consisting of: an aluminum containing oxide layer, an aluminum containing oxynitride layer, and mixtures thereof. Typically, as a yet further optional modification, the further passivation layer is selected from the group consisting of: the further passivation layer being an Al₂O_{X} layer wherein X is in the range of 2 to 3, the further passivation layer having an average oxygen content of 40% atomic oxygen or more in the form of aluminum oxide, and the further passivation layer being an AlO_{X}N_{Y} layer and wherein X is in the range of 2 to 2.9 and/or the further passivation layer has a refractive index of 1.55 to 2.1. Some embodiments may additionally or alternatively have an antireflection layer covering the further passivation layer and/or a reflection layer deposited between the passivation layer and the back contact layer. As an example, for the embodiments described herein above, an n-doped silicon wafer can be used and/or the thickness of the first passivation layer and/or the thickness of the further passivation layer is about 100 nm or less, preferably the thickness is in the range of 10 nm to 100 nm.

According to yet further embodiments, a method of manufacturing a solar cell layer stack having a back contact layer, is provided. The method includes: providing a doped silicon wafer substrate, depositing a further layer on the substrate, wherein the further layer is doped for generation of a p-n-junction with the doped silicon wafer substrate, and reactive sputtering a passivation layer on the doped silicon wafer substrate or on the further layer. The reactive sputtering includes flowing an unreactive gas and an oxygen containing gas, an argon containing gas and a nitrogen containing gas, or an unreactive gas and an oxygen containing gas and a nitrogen containing gas in the processing region for depositing the passivation layer. The method of manufacturing further includes annealing the passivation layer. Further additional or alternative modifications include: depositing a further doped silicon layer on the doped wafer substrate to generate a p-n-junction, reactive sputtering a further passivation layer onto the further doped silicon layer, the reactive sputtering of the further passivation layer includes flowing an argon containing gas and an oxygen containing gas, or an argon containing gas and an oxygen containing gas and a nitrogen containing gas in the processing region, and annealing the further passivation layer; the reactive sputtering of the passivation layer and/or the reactive sputtering of the further passivation layer includes flowing an argon containing gas and an oxygen containing gas and a nitrogen containing gas in the processing region; and wherein the passivation layer and/or the further passivation layer is an Al₂O_{X} layer wherein X is in the range of 2 to 3; and/or the annealing of the passivation layer and/or the annealing of the further passivation layer is conducted at a temperature T in the range of 300°C to 1200°C and a time t in the range of 2 min to 30 min. Yet further embodiments, which can be combined with other embodiments described herein, include depositing an antireflection layer covering the further passivation layer and/or depositing an reflection layer between the passivation layer and the back contact layer.

According to yet further embodiments a system for depositing solar cell layer stack, preferably a layer stack according to embodiments described herein, is provided. The system includes one or more chambers adapted for depositing at least a first and a second passivation layer under vacuum atmosphere on a doped silicon wafer substrate, wherein a first deposition region is provided for depositing the first passivation layer and the second deposition region is provided for depositing the second passivation layer. The system further includes at least one sputter cathode for depositing at least a first sputtered passivation layer, wherein the passivation layer is selected from the group consisting of: an aluminum containing oxide layer, an aluminum containing oxynitride layer, and mixtures thereof, the cathode being provided for sputtering in the first deposition region or the second deposition region, and wherein the first deposition region and the second deposition region are in vacuum communication with each other such that the substrate is maintained under vacuum atmosphere while transferred from the first deposition region to the second deposition. The system further comprises an anneal station adapted for annealing the first sputtered passivation layer. According to optional implementations thereof, adjacent chambers can be vacuum sealed with respect to each other for transfer between back-side and front-side deposition, intermediate chambers for transfer of the substrate from a front-side passivation deposition chamber to a back-side passivation deposition layer can be provided, wherein the intermediate chamber are adapted for transferring the substrate under vacuum conditions, or different deposition regions for the front-side passivation layer and the back-side passivation layer can be provided within one chamber, which is adapted for low pressure operation as described above. In the latter case, transfer of the substrate from the first deposition region to the second deposition might even be neglected. According to further typical embodiments, which can be combined with other embodiments described herein, the anneal station can be a rapid thermal anneal station which is provided in an anneal chamber or which is integrated for in-situ annealing after the first deposition region.

While the foregoing is directed to embodiments of the invention, other and further embodiments of the invention may be devised without departing from the basic scope thereof, and the scope thereof is determined by the claims that follow.

## Claims

1. A solar cell layer stack comprising:
a doped silicon wafer substrate (101);
a further layer (102) deposited on the substrate, wherein the further layer is doped for generation of a p-n-junction with the doped silicon wafer substrate; and
a first sputtered and annealed passivation layer (112, 114) deposited on the doped silicon wafer substrate (101) or the further layer (102), wherein the passivation layer is selected from the group consisting of: an aluminum containing oxide layer, an aluminum containing oxynitride layer, and mixtures thereof.

2. The solar cell layer stack according to claim 1, wherein the first passivation layer is selected from the group consisting of: the first passivation layer comprises mainly Al₂O_{X} wherein X is in the range of 2 to 3, the first passivation layer having an average oxygen content of 40% atomic oxygen or more in the form of aluminum oxide, and the first passivation layer comprises mainly Al₂O_{X}N_{Y} layer and wherein X is in the range of 2 to 2.9.

3. The solar cell layer stack according to any of claims 1 to 2, wherein the first passivation layer has a refractive index of 1.55 to 2.1.

4. The solar cell layer stack according to any of claims 1 to 3, further comprising:
a further sputtered and annealed passivation layer (114; 112) on the side of the wafer substrate opposing the first sputtered and annealed passivation layer, wherein the further passivation layer is selected from the group consisting of: an aluminum containing oxide layer, , an aluminum containing oxynitride layer, and mixtures thereof.

5. The solar cell layer stack according to claim 4, wherein the further passivation layer is selected from the group consisting of: the further passivation layer comprising mainly Al₂O_{X} wherein X is in the range of 2 to 3, the further passivation layer having an average oxygen content of 40% atomic oxygen or more in the form of aluminum oxide, and the further passivation layer comprising mainly Al₂O_{X}N_{Y} layer and wherein X is in the range of 2 to 2.9.

6. The solar cell layer stack according to any of claims 4 to 5, further comprising:
an antireflection layer (106) covering the first passivation layer or the further passivation layer.

7. The solar cell layer stack according to any of claim 1 to 6, further comprising:
a reflection layer (202) deposited between the substrate (101) and a back contact layer (104).

8. The solar cell layer stack according to any of claims 1 to 7, wherein the substrate (101) is an n-doped silicon wafer.

9. The solar cell layer stack according to any of claims 1 to 8, wherein the thickness of the first passivation layer and/or the thickness of the further passivation layer is about 100 nm or less, preferably the thickness is in the range of 10 nm to 100 nm.

10. A method of manufacturing a solar cell layer stack, the method comprising:
providing a doped silicon wafer substrate (101);
depositing a further layer (102) on the substrate, wherein the further layer is doped for generation of a p-n-junction with the doped silicon wafer substrate;
reactive sputtering a first passivation layer (112, 114) on the doped silicon wafer substrate (101) or on the further layer (102),, the reactive sputtering comprises:
flowing an unreactive gas and an oxygen containing gas, or an unreactive gas and an oxygen containing gas and a nitrogen containing gas in the processing region for depositing the passivation layer;
annealing the passivation layer.

11. The method according to claim 10, further comprising:
reactive sputtering a further passivation layer on the substrate or on the further layer and on the side of the substrate opposing the first passivation layer, the reactive sputtering of the further passivation layer comprises:
flowing an unreactive gas and an oxygen containing gas, or an unreactive gas and an oxygen containing gas and a nitrogen containing gas in the processing region; and
annealing the further passivation layer.

12. The method according to any of claims 10 to 11, wherein the reactive sputtering of the passivation layer and/or the reactive sputtering of the further passivation layer comprises flowing an argon containing gas and an oxygen containing gas and a nitrogen containing gas in the processing region; and
wherein the passivation layer and/or the further passivation layer comprises mainly AlO_{X}N_{Y} wherein X is in the range of 2 to 3.

13. The method according to any of claims 10 to 12, wherein the annealing of the passivation layer and/or the annealing of the further passivation layer is conducted at a temperature T in the range of 300°C to 1200°C and a time t in the range of 30 seconds to 30 min.

14. The method according to any of claims 10 to 13, further comprising:
depositing an antireflection layer covering the first passivation layer or the further passivation layer.

15. The method according to any of claims 10 to 14, further comprising:
depositing an reflection layer between the substrate and a back contact layer.

16. A system for depositing solar cell layer stack according to any of claims 1 to 9, the system comprising:
one or more chambers adapted for depositing at least a first and a second passivation layer under vacuum atmosphere on a doped silicon wafer substrate (101) , wherein a first deposition region is provided for depositing the first passivation layer and the second deposition region is provided for depositing the second passivation layer;
at least one sputter cathode for depositing at least a first sputtered and annealed passivation layer (112, 114), wherein the passivation layer is selected from the group consisting of: an aluminum containing oxide layer, an aluminum containing oxynitride layer, and mixtures thereof, the cathode being provided for sputtering in the first deposition region or the second deposition region;
wherein the first deposition region and the second deposition region are in vacuum communication with each other such that the substrate is maintained under vacuum atmosphere while transferred from the first deposition region to the second deposition; and
an anneal station adapted for annealing the first sputtered passivation layer.

17. The system according to claim 16, wherein the anneal station is a rapid thermal anneal station provided in an anneal chamber (312) or integrated for in-situ annealing after deposition of the passivation layer in the first deposition region or the second deposition region.

## Amended claims

### Amended claims in accordance with Rule 137(2) EPC.

**1.** A solar cell layer stack comprising:
a doped silicon wafer substrate (101);
a further layer (102) deposited on the substrate, wherein the further layer is doped for generation of a p-n junction with the doped silicon wafer substrate; and
a first sputtered and annealed passivation layer (112, 114) deposited on the doped silicon wafer substrate (101) or the further layer (102), wherein the passivation layer is selected from the group consisting of: an aluminum containing oxide layer, an aluminum containing oxynitride layer, and mixtures thereof,
wherein the passivation layer (112, 114) comprises a passivation assist layer including silicon nitride.

**2.** The solar cell layer stack according to claim 1, wherein the first passivation layer is selected from the group consisting of: the first passivation layer comprises mainly Al₂O_{X} wherein X is in the range of 2 to 3, the first passivation layer having an average oxygen content of 40% atomic oxygen or more in the form of aluminum oxide, and the first passivation layer comprises mainly Al₂O_{X}N_{Y} layer and wherein X is in the range of 2 to 2.9.

**3.** The solar cell layer stack according to any of claims 1 to 2, wherein the first passivation layer has a refractive index of 1.55 to 2.1.

**4.** The solar cell layer stack according to any of claims 1 to 3, further comprising:
a further sputtered and annealed passivation layer (114; 112) on the side of the wafer substrate opposing the first sputtered and annealed passivation layer, wherein the further passivation layer is selected from the group consisting of: an aluminum containing oxide layer, an aluminum containing oxynitride layer, and mixtures thereof.

**5.** The solar cell layer stack according to claim 4, wherein the further passivation layer is selected from the group consisting of: the further passivation layer comprising mainly Al₂O_{X} wherein X is in the range of 2 to 3, the further passivation layer having an average oxygen content of 40% atomic oxygen or more in the form of aluminum oxide, and the further passivation layer comprising mainly Al₂O_{X}N_{Y} layer and wherein X is in the range of 2 to 2.9.

**6.** The solar cell layer stack according to any of claims 4 to 5, further comprising:
an antireflection layer (106) covering the first passivation layer or the further passivation layer.

**7.** The solar cell layer stack according to any of claim 1 to 6, further comprising:
a reflection layer (202) deposited between the substrate (101) and a back contact layer (104).

**8.** The solar cell layer stack according to any of claims 1 to 7, wherein the substrate (101) is an n-doped silicon wafer.

**9.** The solar cell layer stack according to any of claims 1 to 8, wherein the thickness of the first passivation layer and/or the thickness of the further passivation layer is about 100 nm or less, preferably the thickness is in the range of 10 nm to 100 nm.

**10.** A method of manufacturing a solar cell layer stack, the method comprising:
providing a doped silicon wafer substrate (101);
depositing a further layer (102) on the substrate, wherein the further layer is doped for generation of a p-n junction with the doped silicon wafer substrate;
reactive sputtering a first passivation layer (112, 114) on the doped silicon wafer substrate (101) or on the further layer (102), wherein the reactive sputtering includes middle frequency sputtering having frequencies in the range of 5 kHz to 100 kHz and the reactive sputtering comprises:
flowing an unreactive gas and an oxygen containing gas, or an unreactive gas and an oxygen containing gas and a nitrogen containing gas in the processing region for depositing the passivation layer;
annealing the passivation layer.

**11.** The method according to claim 10, further comprising:
reactive sputtering a further passivation layer on the substrate or on the further layer and on the side of the substrate opposing the first passivation layer, the reactive sputtering of the further passivation layer comprises:
flowing an unreactive gas and an oxygen containing gas, or an unreactive gas and an oxygen containing gas and a nitrogen containing gas in the processing region; and
annealing the further passivation layer.

**12.** The method according to any of claims 10 to 11, wherein the reactive sputtering of the passivation layer and/or the reactive sputtering of the further passivation layer comprises flowing an argon containing gas and an oxygen containing gas and a nitrogen containing gas in the processing region; and
wherein the passivation layer and/or the further passivation layer comprises mainly AlO_{X}N_{Y} wherein X is in the range of 2 to 3.

**13.** The method according to any of claims 10 to 12, wherein the annealing of the passivation layer and/or the annealing of the further passivation layer is conducted at a temperature T in the range of 300°C to 1200°C and a time t in the range of 30 seconds to 30 min.

**14.** The method according to any of claims 10 to 13, further comprising:
depositing an antireflection layer covering the first passivation layer or the further passivation layer.

**15.** The method according to any of claims 10 to 14, further comprising:
depositing a reflection layer between the substrate and a back contact layer.

**16.** A system for depositing a solar cell layer stack according to any of claims 1 to 9, the system comprising:
one or more chambers adapted for depositing at least a first and a second passivation layer under vacuum atmosphere on a doped silicon wafer substrate (101), wherein a first deposition region is provided for depositing the first passivation layer and the second deposition region is provided for depositing the second passivation layer;
at least one sputter cathode configured for middle frequency sputtering having frequencies in the range of 5 kHz to 100 kHz for depositing at least a first sputtered and annealed passivation layer (112, 114), wherein the passivation layer is selected from the group consisting of: an aluminum containing oxide layer, an aluminum containing oxynitride layer, and mixtures thereof, the cathode being provided for sputtering in the first deposition region or the second deposition region;
wherein the first deposition region and the second deposition region are in vacuum communication with each other such that the substrate is maintained under vacuum atmosphere while transferred from the first deposition region to the second deposition region; and
an anneal station adapted for annealing the first sputtered passivation layer.

**17.** The system according to claim 16, wherein the anneal station is a rapid thermal anneal station provided in an anneal chamber (312) or integrated for in-situ annealing after deposition of the passivation layer in the first deposition region or the second deposition region.
